(19) Europäisches Patentamt / European Patent Office / Office européen des brevets

(11) **EP 4 199 318 A1**

(12) **EUROPEAN PATENT APPLICATION**

(43) Date of publication:
**21.06.2023 Bulletin 2023/25**

(21) Application number: **21215730.9**

(22) Date of filing: **17.12.2021**

(51) International Patent Classification (IPC):
*H02K 5/20* (2006.01)   *H02K 9/197* (2006.01)
*F28D 7/04* (2006.01)   *B60H 1/00* (2006.01)
*F28D 7/10* (2006.01)   *H02K 9/193* (2006.01)
*H05K 7/20* (2006.01)   *F28D 21/00* (2006.01)

(52) Cooperative Patent Classification (CPC):
**F28D 7/14; B60H 1/00385; F28D 7/04; F28D 7/087;
F28D 7/106; H05K 7/20872;** B60L 2240/425;
B60L 2240/525; F28D 2021/0028; F28D 2021/004;
F28D 2021/008; F28D 2021/0089; F28D 2021/0094

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Valeo eAutomotive Germany GmbH
91056 Erlangen (DE)**

(72) Inventor: **RAYYA, Monzer
91056 Erlangen (DE)**

(74) Representative: **Valeo Powertrain Systems
Service Propriété Intellectuelle
Immeuble le Delta
14, avenue des Béguines
95892 Cergy Pontoise (FR)**

(54) **A HEAT EXCHANGER OF AN ELECTRIC MODULE**

(57) The invention concerns a heat exchanger (50) configured to dissipate heat generated by an electric module (100) of an automobile vehicle. The heat exchanger (50) comprises a housing (51), a first channel (10) being formed in the housing (51) and being configured to allow a first cooling medium to flow through, and a second channel (20) which is formed in the housing (51) and is configured to allow a second cooling medium to flow through, wherein the first channel (10) is inserted into the second channel (20) in a way that the first channel (10) is surrounded by the second channel (20).

Figure 3

EP 4 199 318 A1

## Description

### FIELD OF THE INVENTION

The present invention concerns equipment for an automotive vehicle, such as an electric vehicle (EV) or a hybrid vehicle (HV).

The present invention relates, in particular, to a heat exchanger configured to efficiently dissipate heat generated by an electric module of an automotive vehicle.

### BACKGROUND OF THE INVENTION

An electric module of an electric vehicle or a hybrid vehicle, such as an electric drive, comprises devices such as a motor, a gearbox and an inverter, etc. During operation of the electric module, the devices and components generate heat and must be cooled to be operational. Efficient cooling of the electric module makes it possible to increase the service life of the electric module. Therefore, the electric module comprises a cooling system for dissipating the heat generated by the devices and components of the electric module.

The cooling system comprises, a first cooling circuit configured to dissipate the heat generated by the motor and the gearbox, and a second cooling circuit configured to dissipate the heat generated by the inverter. In general, the first cooling circuit is an oil cooling circuit and the second cooling circuit is a water cooling circuit.

The cooling system comprises further a heat exchanger located between the first and the second cooling circuits. However, the efficiency of heat dissipation achieved by existing heater exchangers are not efficient enough.

There is therefore a need to improve the structure of the heat exchanger in order to obtain a better heat exchange efficiency so as to improve the heat dissipation of the electric module of the vehicle.

### SUMMARY OF THE INVENTION

The present invention concerns a heat exchanger configured to dissipate heat generated by an electric module of an automobile vehicle. The heat exchanger comprises a housing, a first channel being formed in the housing and being configured to allow a first cooling medium to flow through, and a second channel which is formed in the housing and is configured to allow a second cooling medium to flow through, wherein the first channel is inserted into the second channel in a way that the first channel is surrounded by the second channel.

Therefore, the heat exchanger according to the present invention allows a better heat exchange efficiency so as to improve the heat dissipation of the electric module of the vehicle.

According to an embodiment, the first channel is surrounded by different portions of the second channel, said different portions of the second channel being adjacent to the first channel.

According to an embodiment, the first and the second channels are respectively a serpentine channel. Alternatively, the first and the second channels are respectively a spiral channel.

Advantageously, the first channel comprises a first inlet configured to conduct the first cooling medium, and plural tubes which are parallel to each other and are connected to the first inlet, wherein the tubes are serpentine tubes or spiral tubes.

According to an embodiment, the heat exchanger and a chamber defined by the housing of the heat exchanger are respectively in a shape of a cube or a rectangular cuboid, or, alternatively, in a shape of a cylinder.

Preferably, the tubes of the first channel are immersed into the flowing second cooling medium in the second channel.

According to an embodiment, the heat exchanger comprises one or plural compartment walls configured to define the second channel.

According to an embodiment, the heat exchanger comprises plural compartment walls, each of which comprises two ends, and only one of the two ends is fixed to one of inner walls of the chamber of the housing.

Advantageously, the compartment walls comprise first and second compartment walls. The inner walls of the chamber of the housing comprise a first and a second inner walls which are opposite to each other. The first compartment walls are fixed to the first inner wall, and the second compartment walls are fixed to the second inner wall. The first and the second compartment walls are interlaced.

Alternatively, the heat exchanger comprises a spiral-shaped compartment wall located in the chamber of the housing and between two parallel sides of the housing.

Preferably, the first channel comprises an inflow region comprising inflow portions, one of the inflow portions comprising the first inlet; the tubes being connected to the inflow portions of the inflow region, wherein compared to the inflow portions which are more distant from the first inlet, the inflow portions which are closer to the first inlet present respectively a greater inflow portion diameter so as to adjust the velocity profile inside the tubes. As mentioned above, the tubes are serpentine tubes or spiral tubes.

According to an embodiment, compared to the tubes which are more distant from the first inlet, the tubes which are closer to the first inlet respectively present a greater inner diameter in order to adjust the velocity profile inside the tubes, wherein the tubes are serpentine tubes or spiral tubes.

Advantageously, the one or plural compartment walls, such as the first and the second compartment walls or the spiral-shaped compartment wall, are mounted into the housing, wherein the compartment walls and the housing are elements formed separately. Alternatively, the one or plural compartment walls are formed integrally with the housing by a casting process or by a milling process.

Preferably, the serpentine tubes or the spiral tubes are made of a material of high thermal conductivity.

According to another embodiment, the first and the second channels are respectively a flat or a wavy serpentine channel or a flat spiral channel formed in the heat exchanger, the first and the second channels presenting each an elongated rectangular cross-section; the first channel being completely inserted into the second channel.

Advantageously, the first and the second channels are respectively a flat serpentine tube mounted in a chamber defined by the housing; the widths of the flat serpentine tubes being both approximately equal to the width of the chamber defined by the housing. Alternatively, the first and the second channels are respectively a flat spiral tube mounted in a cylinder-shaped chamber defined by the housing; the widths of the flat spiral tubes being both approximately equal to the longitudinal length of the cylinder-shaped chamber defined by the housing. Alternatively, the first and the second channels are formed integrally with the housing so as to be embedded into the heat exchanger. In an other example, the tube can be a wavy serpentine instead a flat serpentine. Preferably, the first cooling medium flows through the first channel according to a first flow direction, and the second cooling medium flows through the second channel according to a second flow direction which is opposite to the first flow direction.

According to an embodiment, the first and the second channels are formed throughout the whole volume of the heat exchanger.

Furthermore, the present invention concerns an electric module comprising an electric motor, an inverter and a heat exchanger as described above.

These and other objects, features, aspects and advantages of the present invention will become apparent to those skilled in the art from the following detailed description, which, taken in conjunction with the annexed drawings, discloses preferred embodiments of the present invention.

## BRIEF DESCRIPTION OF THE DRAWINGS

The invention will be better understood on reading the description that follows, and by referring to the appended drawings given as non-limiting examples, in which identical references are given to similar objects and in which:

- Figures 1 and 2 illustrate respectively a layout of an electric module comprising a heat exchanger according to an embodiment of the invention;

- Figure 3 illustrates a cross-sectional view of the heat exchanger according to a first embodiment of the invention;

- Figures 4 and 5 illustrate respectively a first channel and a second channel of the heat exchanger according to the first embodiment of the invention;

- Figure 6 illustrates, according to a different perspective, the heat exchanger without its housing according to the first embodiment of the invention;

- Figure 7 illustrates an example in which the first channel comprising inflow portions with different diameters according to the invention;

- Figure 8 illustrates a cross-sectional view of the heat exchanger according to a second embodiment of the invention;

- Figure 9 illustrates, according to a different perspective, the heat exchanger without its housing according to the second embodiment of the invention;

- Figure 10 illustrates the first channel of the heat exchanger according to the second embodiment of the invention;

- Figure 11 illustrates a cross-sectional view of the heat exchanger according to a third embodiment of the invention;

- Figures 12 and 13 illustrate respectively the first channel and the second channel of the heat exchanger according to the third embodiment of the invention;

- Figure 14 illustrates a cross-sectional view of the heat exchanger according to a fourth embodiment of the invention;

- Figure 15 illustrates the first channel of the heat exchanger according to the fourth embodiment;

- Figures 16 illustrates a spiral-shaped compartment configured for defining the second channel of the heat exchanger according to the fourth embodiment; and

- Figure 17 illustrates, according to a different perspective, the heat exchanger without its housing according to the fourth embodiment of the invention.

## DETAILED DESCRIPTION

Several embodiments of the present invention will be detailed hereafter with reference to the drawings. It will be apparent to those skilled in the art from this present disclosure that the following description of these embodiments of the present invention are provided for illustration only and not for the purpose of limiting the invention as defined by the appended claims and their equivalents.

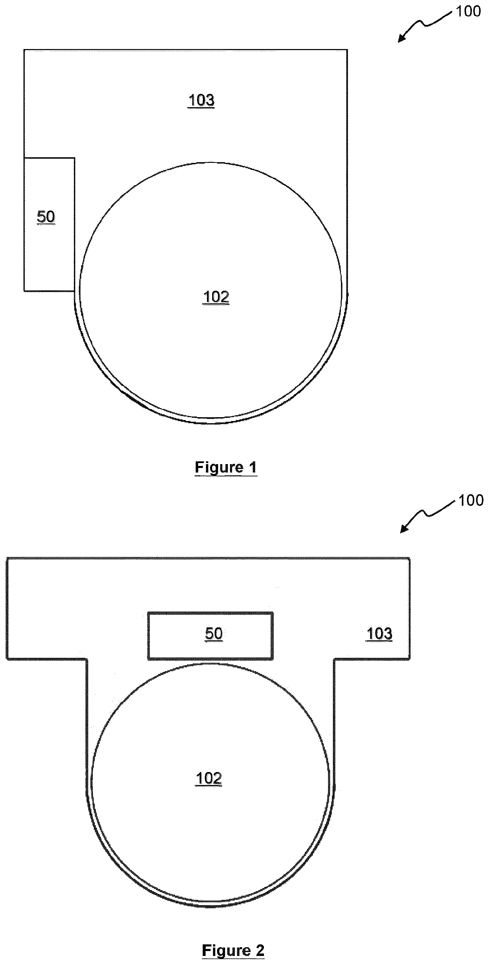

An electric module 100 of an automobile vehicle (e.g. an electric vehicle or a hybrid vehicle) comprises devices (e.g. an electric motor, an inverter, etc) which generate heat during operation, and a heat exchanger 50 configured to dissipate the generated heat. The heat exchanger 50 is located between an electric motor 102 and an inverter 103, as illustrated in Figures 1 and 2. The heat exchanger 50 is in general located between a first cooling circuit of the motor 102 and of a gearbox and a second cooling circuit of the inverter 103. The first and the second cooling circuit are, for example, respectively an oil cooling circuit and a water cooling circuit.

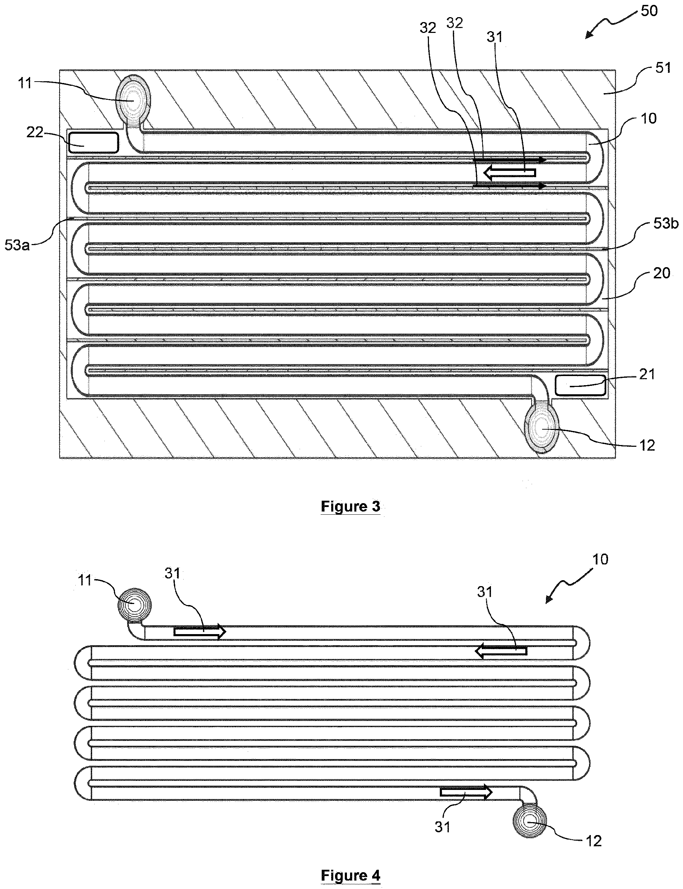

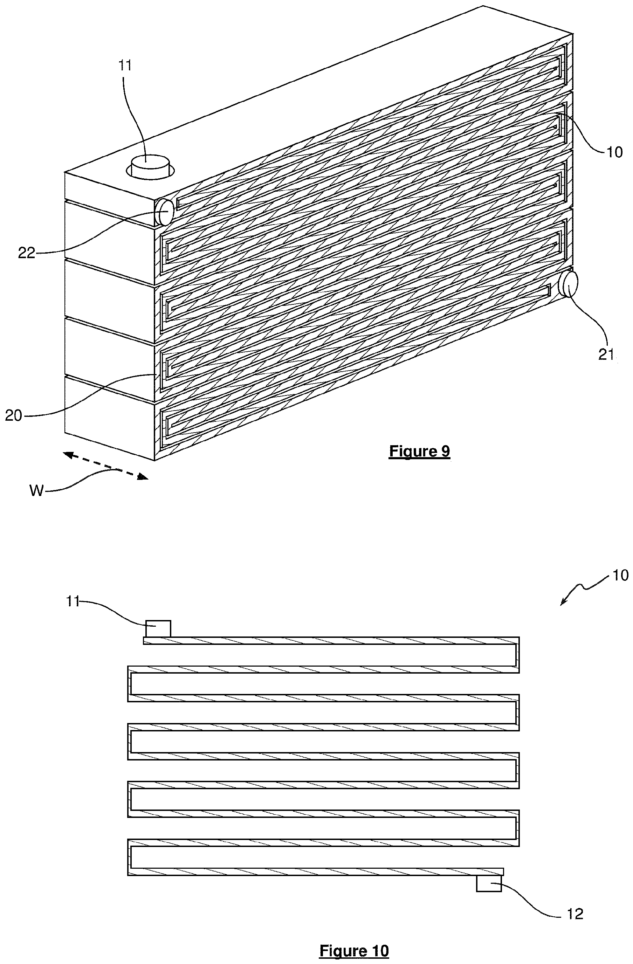

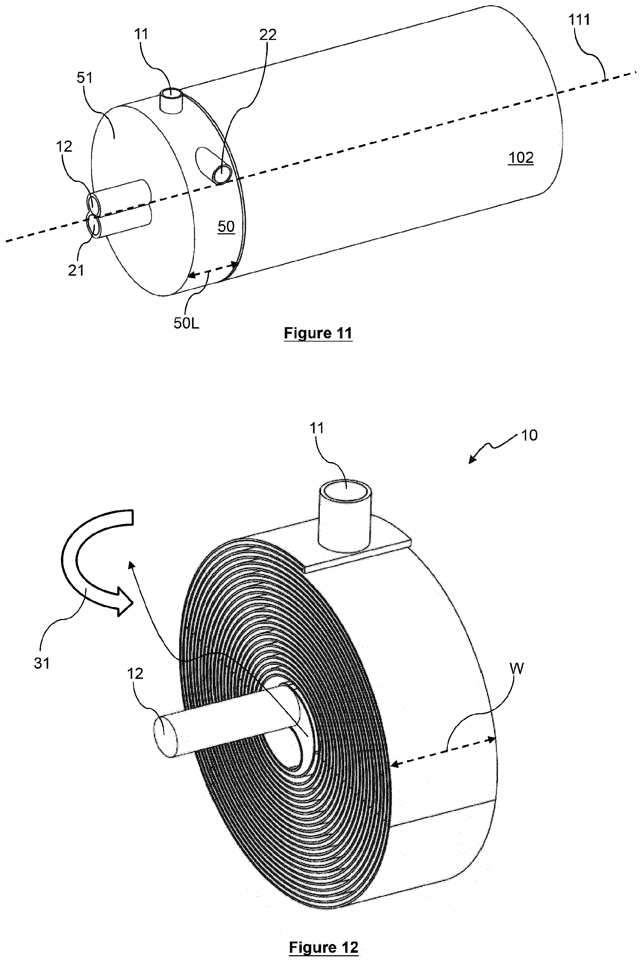

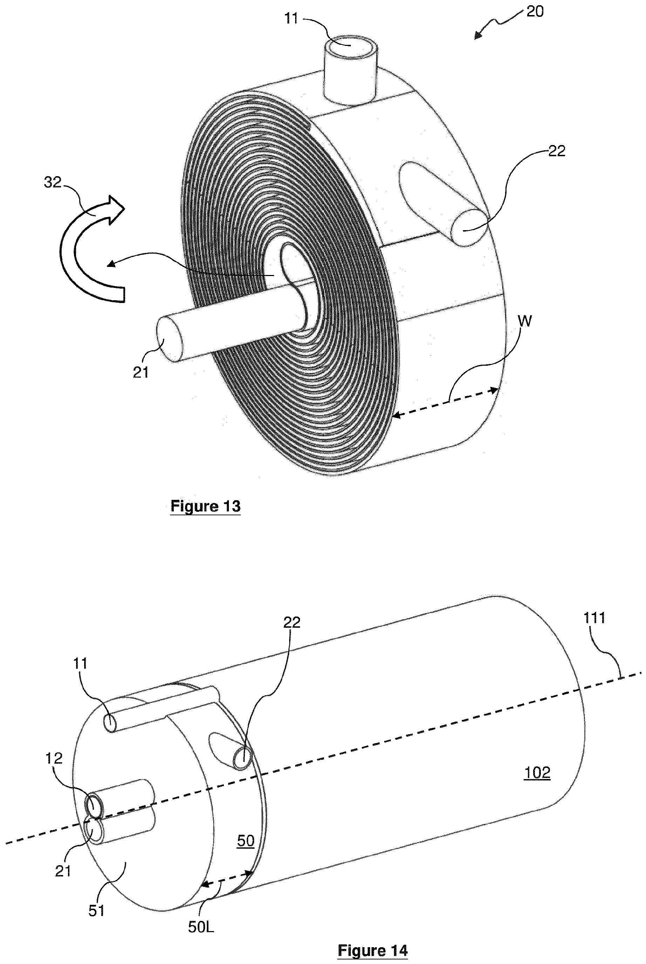

Figures 3 to 7 illustrate the heat exchanger 50 according to a first embodiment of the invention, and Figures 10 to 12 illustrate the heat exchanger 50 according to a second embodiment of the invention. Figures 11 to 13 illustrate the heat exchanger 50 according to a third embodiment of the invention, and Figures 14 to 17 illustrate the heat exchanger 50 according to a fourth embodiment of the invention.

The heat exchanger 50 comprises a housing 51, a first channel 10 and a second channel 20. The housing 51 is preferably made of a metal material such as steel, aluminum or copper. Advantageously, the housing 51 is made of aluminum alloy or copper alloy.

The first channel 10 and the second channel 20, respectively allowing a first cooling medium and a second cooling medium to flow through, are formed in a chamber defined by the housing 51 of the heat exchanger 50. The heat exchanger 50 and the chamber are respectively in a shape of a cube or a rectangular cuboid, as illustrated in Figures 1 to 10 of the first and the second embodiments of the invention. Alternatively, the heat exchanger 50 and the chamber are respectively in a shape of a cylinder, as illustrated in Figures 11 to 17 of the third and the fourth embodiments of the invention.

Preferably, the first and the second channels 10, 20 are respectively a serpentine channel, as described in the first and the second embodiments. Alternatively, the first and the second channels 10, 20 are respectively a spiral channel, as described in the third and the fourth embodiments which will be described more in detail after the description of the first and the second embodiments.

The first channel 10 is inserted into the second channel 20 in a way that the first channel 10 is surrounded by the second channel 20. More precisely, the first channel 10 is surrounded by different portions of the second channel 20, said different portions being adjacent to the first channel 10. This allows thus a heat exchange between the first and the second channels 10, 20 occurs through channel walls of the first and the second channels 10, 20 as well as through the first and the second cooling media. The first and the second channels 10 and 20 are preferably formed throughout the whole volume of the heat exchanger 50.

The first channel 10 comprises a first inlet 11 and a first outlet 12 which are respectively configured to conduct and to discharge the first cooling medium. The first inlet 11 and the first outlet 12 can be switched if needed. The first cooling medium flows through the first channel 10 according to a first flow direction 31. The first cooling medium is a thermal fluid, and is preferably oil, water, glycol or a glycol-water mixture. Similarly, the second channel 20 comprises a second inlet 21 and a second outlet 22 which are respectively configured to conduct and to discharge a second cooling medium. The second inlet 21 and the second outlet 22 can be switched if needed. The second channel 20 allows the second cooling medium to flow through according to a second flow direction 32. The second cooling medium is a thermal fluid, and is preferably water, a glycol-water mixture, a glycol or oil. The second cooling medium can be identical or different from the first cooling medium.

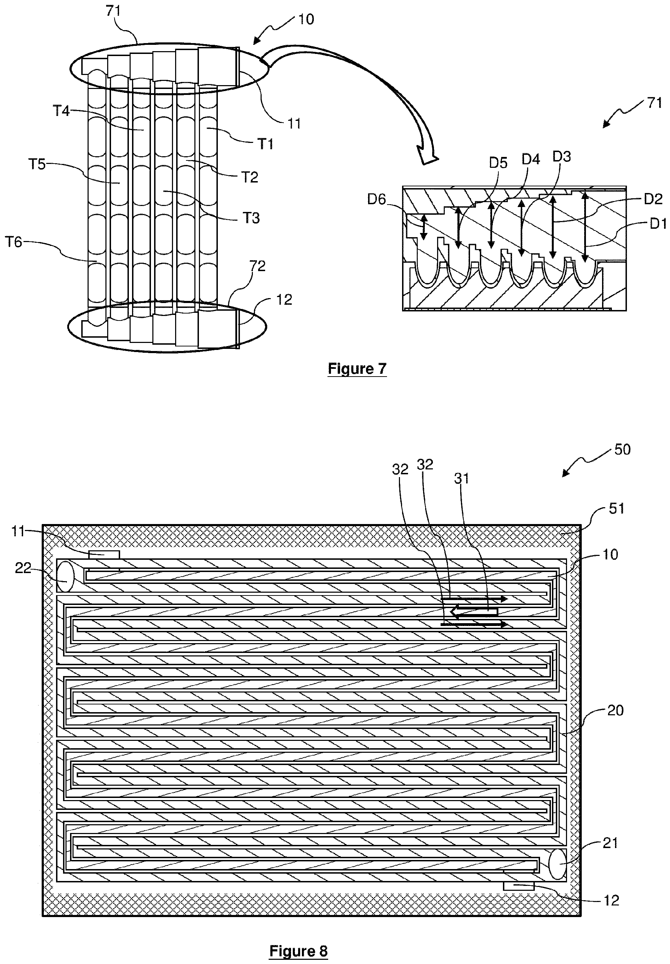

The second flow direction 32 can be opposite to the first flow direction 31, as depicted in the first and the second embodiments illustrated in Figures 3 and 8. According to an alternative embodiment (not illustrated in figures), the second flow direction 32 is parallel to the first flow direction 31. Especially, the second flow direction 32 may be same with the first flow direction 31.

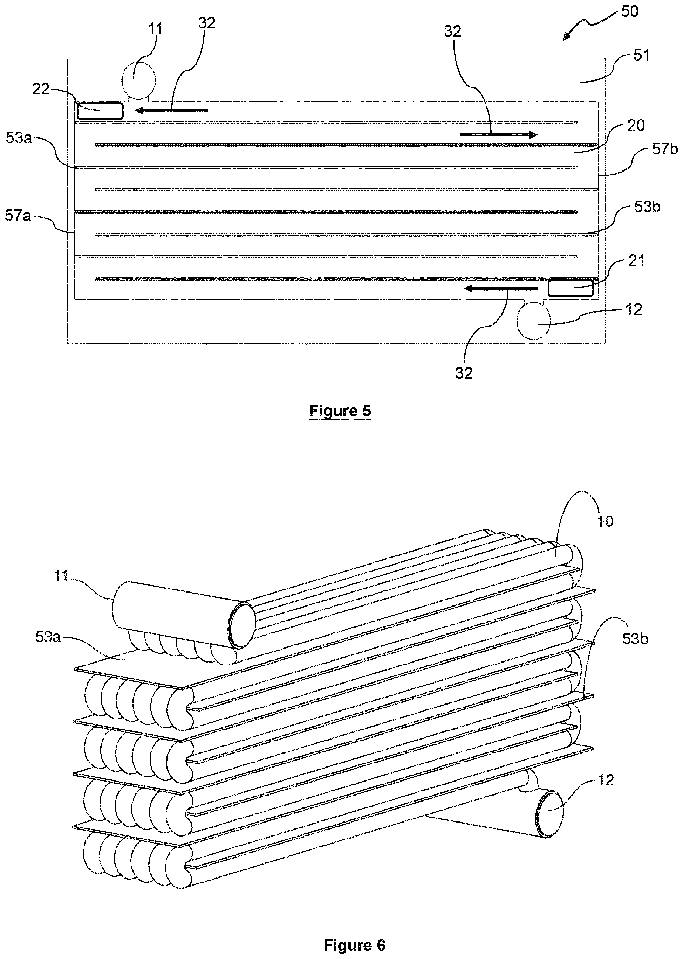

As mentioned above, Figures 3 to 7 illustrate the heat exchanger 50 according to the first embodiment of the invention. Figure 3 illustrates a cross-sectional view of the heat exchanger 50. Figure 6 illustrates, according to a different perspective, the heat exchanger 50 without its housing 51. Figures 4 and 5 illustrate respectively the first channel 10 and the second channel 20 of the heat exchanger 50. Figure 7 illustrates an example in which the first channel 10 comprises an inflow region 71 comprising inflow portions with different inner diameters. In the first embodiment, the first and the second channels 10 and 20 are respectively a serpentine channel.

According to the first embodiment illustrated in Figures 3 to 7, the first channel 10 comprises the inflow region 71 comprising the first inlet 11, an outflow region 72 comprising the first outlet 12, and n tubes for decreasing a fluid pressure drop in the whole first channel 10, wherein "n" is a total number of the tubes. Each of the tubes are respectively numbered as Ti, wherein "i" is an index of the tube Ti, and i = 1, 2, ..., n. The tubes T1 to Tn are parallel to each other. A sum of outer diameters of the n tubes of the first channel 10 is approximately equal to the width of the chamber defined by the housing 51. The tubes of the first channel 10 are serpentine tubes. In the present embodiment, the first channel 10 comprises six parallel serpentine tubes T1, T2... to T6, and the number "n" is equal to 6. The invention is not limited to the number of the serpentine tubes utilized to form the first channel 10.

The serpentine tubes are preferably made of a material of high thermal conductivity, such as copper or aluminum. The serpentine tubes present each a cross-section which can be round, square, or rectangular etc. For example, as illustrated in Figure 6, the serpentine tubes T1 to T6 of the first channel 10 are circular tubes and their cross-sections are round. The invention is nevertheless limited to the shape of the cross-sections of the serpentine tubes.

The inflow region 71 comprises n inflow portions which present respectively an inner diameter Di (named "inflow portion diameter" in the following paragraphs), wherein "i" is as an index of the inflow portion diameter Di, i = 1, 2, ..., n. The serpentine tube Ti comprises one end being connected to the corresponding inflow portion which presents the inflow portion diameter Di, and the other end being connected to the outflow region 72, as depicted in Figure 7. The first cooling medium flows, via the first inlet 11 and the inflow portions of the inflow region 71, into the serpentine tubes, and is then discharged from the outflow region 72 and the first outlet 12.

The serpentine tube T1 is connected to the inflow portion which comprises the first inlet 11 and presents the inflow portion diameter D1. The inflow portion diameter D1 is equal to an inner diameter of the first inlet 11. The serpentine tubes Ti (i.e. i = 2, 3,..., n) with a greater index "i", compares to those with a smaller index "i", are more distant from the first inlet 11. For example, among the serpentine tubes T1 to T6 illustrated in Figure 7, the serpentine tube T6 is the most distant from the first inlet 11. Compared to the serpentine tube T4, the serpentine tube T2 is closer to the first inlet 11.

According to an embodiment not illustrated in figures, the inflow portion diameter D1 to Dn of the inflow portions are equal to the inner diameter of the first inlet 11. Alternatively, in order to ensure that all of the serpentine tubes T1 to Tn present a same mass flow rate, except the inflow portion diameter D1 being equal to the inner diameter of the first inlet 11, the inflow portion diameters Di corresponding to the serpentine tubes Ti, wherein i = 2, 3,..., n, are respectively calculated in function of an velocity "U" (m/s) of the first cooling medium measured in the first inlet 11, a given total volume flow rate "V1" ($m^3$/s), and the value of the index "i" (i = 2, 3,..., n).

More precisely, a volume flow rate "Vi" ($m^3$/s) of the inflow portion corresponding to the serpentine tube Ti is firstly calculated according to Equation (1), wherein i = 2, 3,..., n:

$$Vi = \frac{V1}{i} \qquad \text{Equation (1)}$$

It is noted that the given total volume flow rate "V1" is the volume flow rate of the inflow portion corresponding to the serpentine tube T1, and is equal to a sum of the volume flow rate "Vi", wherein i = 2, 3,..., n.

In order to have similar flow rate in every tube, the volume flow rate in the serpentine tubeTn = V1/n

While the volume flow rate in the in- and outflow portion (71 in figure 7) = V1/ i

An inflow portion surface "Ai" ($mm^2$) of the inflow portion corresponding to the serpentine tube Ti is then calculated according to Equation (2):

$$Ai = \frac{Vi}{U} \qquad \text{Equation (2)}$$

The inflow portion diameter "Di" (mm) of the inflow portion corresponding to the serpentine tube Ti is calculated according to Equation (3):

$$Di = \sqrt{\frac{4 \times Ai}{\pi}} \qquad \text{Equation (3)}$$

Therefore, compared to the inflow portions which are more distant from the first inlet 11, the inflow portions which are closer to the first inlet 11 present respectively a greater inflow portion diameter Di, as represented in the following formula: D1 > D2 > ... > Dn.

The serpentine tubes T1 to Tn of the first channel 10 present respectively an inner diameter Ri, wherein "i" is an index of the inner diameter Ri, i = 1, 2, ..., n. According to an embodiment, the inner diameter R1 to Rn of the serpentine tubes T1 to Tn are equal. Alternatively, in order to adjust the velocity profile inside the serpentine tubes T1 to Tn, the serpentine tubes which are closer to the first inlet 11 respectively present, compared to the serpentine tubes which are more distant from the first inlet 11, a greater inner diameter Ri, as represented in the following formula: R1 > R2 > ... > Rn. In addition, tube walls of the serpentine tubes T1, T2... to Tn of the first channel 10 are respectively comprised preferably between 0.1 mm to 10 mm.

As for the second channel 20 according to the first embodiment, it is formed in a way to allow the first channel 10 to be inserted into the second channel 20, so that the serpentine tubes T1 to Tn of the first channel 10 are immersed into the flowing second cooling medium in the second channel 20.

The heat exchanger comprises a plurality of compartment walls 53a, 53b configured to define the second channel 20. The compartment walls 53a, 53b are preferably made of a metal material such as steel, aluminum or copper. Advantageously, the compartment walls 53a, 53b is made of aluminum alloy or copper alloy. Alternatively, the compartment walls 53a, 53b are made of a polymer material. Each of the compartment walls 53a, 53b comprises two ends, and only one of the two ends is fixed to one of inner walls (e.g. 57a, 57b) of a chamber of the housing 51.

More precisely, the second channel 20 is defined by a first and a second inner walls 57a, 57b of the chamber of the housing 51, and the compartment walls comprising the first compartment walls 53a and the second compartment walls 53b. The first compartment walls 53a are fixed to the first inner wall 57a which is opposite to the second inner wall 57b. The second compartment walls 53b are fixed to the second inner wall 57b. The first and the second compartment walls 53a, 53b are interlaced.

The first and the second compartment walls 53a, 53b and the housing 51 can be elements formed separately. The first and the second compartment walls 53a, 53b are mounted into the housing 51. Alternatively, the first and the second compartment walls 53a, 53b are formed integrally with the housing 51 by, for example, a casting process or a milling process.

Figure 8 illustrates a cross-sectional view of the heat exchanger 50 according to the second embodiment of the invention. Figure 9 illustrates, according to a different perspective, the heat exchanger 50 without its housing 51 according to the second embodiment. Figure 10 illustrates the first channel 10 according to the second embodiment. In the second embodiment, the first and the second channels 10 and 20 are respectively a serpentine channel.

As depicted in Figures 8 to 10, the first and the second channels 10, 20 are respectively a flat serpentine channel formed in the heat exchanger 50. The first channel 10 is completely inserted into the second channel 20 in a way that the first channel 10 is surrounded by different portions of the second channel 20 which are adjacent to the first channel 10. Different from the first embodiment, the first channel 10 of the second embodiment is not directly immersed in the second cooling medium. The first and the second channels 10 and 20 present each an elongated rectangular cross-section. The widths W of the flat serpentine channels 10, 20 are both approximately equal to the width of the chamber defined by the housing 51.

According to an embodiment, the first and the second channels 10, 20 are respectively a flat serpentine tube mounted in the chamber defined by the housing 51 of the heat exchanger 50. The flat serpentine tubes 10, 20 are preferably made of a material of high thermal conductivity, such as copper or aluminum. The widths (W) of the flat serpentine tubes 10, 20 are both approximately equal to the width of the chamber defined by the housing 51. The flat serpentine tubes 10, 20 and the housing 51 are elements formed separately. Alternatively, the first and the second channels 10, 20 can be formed integrally with the housing 51. In this way, the first and the second channels 10, 20 are embedded, without being mounted, into the heat exchanger 50. The width of the first channel 10 and that of the second channel 20 are both approximately equal to the width of the heat exchanger 50.

The heat exchanger 50 allows thus a heat exchange between the first and the second channels 10, 20 to occur through channel walls of the first and the second channels 10, 20 and the first and the second cooling media.

In the following third and fourth embodiments, the heat exchanger 50 is located adjacent to the electric motor 102, as illustrated in Figures 11 and 14. The electric motor 102 is in a shape of a cylinder, and rotates about a rotation axis which is also a central axis 111 of the heat exchanger 50. The heat exchanger 50 is attached to one of two ends of the electric motor 102. The heat exchanger 50 is, as mentioned above, in a shape of a cylinder presenting a longitudinal length 50L defined by a distance measured along with the central axis 111 and between two parallel sides of the heat exchanger 50. The heat exchanger 50 is preferably in a shape of a flat cylinder. The longitudinal length 50L of the heat exchanger 50 is smaller than that of the of the electric motor 102, and, for example, is greater than 1/6 and smaller than 1/2 of the longitudinal length of the electric motor 102.

The first inlet 11 of the first channel 10 is preferably located on a peripheral wall of the housing 51. The second inlet 12 of the first channel 10 is preferably located close to or at the central axis 111 of the heat exchanger 50. The first inlet 11 and the first outlet 12 can be switched if needed. The second inlet 21 of the second channel 20 is preferably located close to or at the central axis 111 of the heat exchanger 50. In other words, the second inlet 21 may be located next to the first outlet 12. The second outlet 22 of the second channel 20 is preferably on the peripheral wall of the housing 51. The second inlet 21 and the second outlet 22 can be switched if needed.

In addition, as mentioned above, different from the first and the second embodiments, the first and the second channels 10, 20 in the third and fourth embodiments are respectively a spiral channel, as described in Figures 12, 13 and 15 to 17. The spiral channels comprise respectively plural turns comprising a first turn, a last turn, and middle turns connected to the first turn and the last turn. Among the rest of the turns of the spiral channel, the first turn is closest to the central axis 111 of the heat exchanger 50 while the last turn is the most distant from the central axis 111. In addition, the spiral channels 10, 20 are preferably formed throughout the whole volume of the heat exchanger 50. The width of the first channel 10 and that of the second channel 20 are both approximately equal to the longitudinal length 50L of the heat exchanger 50.

The heat exchanger 50, the first channel 10 and the second channel 20 of the third embodiment of the invention are depicted respectively in Figures 11 to 13.

As illustrated in Figures 12 and 13, the first and the second channels 10, 20 are respectively a flat spiral channel formed in the heat exchanger 50. The flat spiral channel could have a rough wall or include additional structures .The first channel 10 is completely inserted into the second channel 20 in a way that the first channel 10 is surrounded by different portions of the second channel 20 which are adjacent to the first channel 10. Different from the four or the first embodiments, the first channel 10 of the third embodiment is not directly immersed in the second cooling medium.

The first and the second channels 10 and 20 present each an elongated rectangular cross-section. The widths W of the flat spiral channels 10, 20 are both approximately equal to the longitudinal length of the cylinder-shaped chamber defined by the housing 51.

According to an embodiment, the first and the second channels 10, 20 are respectively a flat spiral tube mounted in the cylinder-shaped chamber defined by the housing 51 of the heat exchanger 50. The flat spiral tubes 10, 20 are preferably made of a material of high thermal conductivity, such as copper or aluminum. The widths W of the flat spiral tubes 10, 20 are both approximately equal to the longitudinal length of the cylinder-shaped chamber. The flat spiral tubes 10, 20 and the housing 51 are elements formed separately. Alternatively, the first and the second channels 10, 20 can be formed integrally with the housing 51. In this way, the first and the second channels 10, 20 are embedded, without being mounted, into the heat exchanger 50.

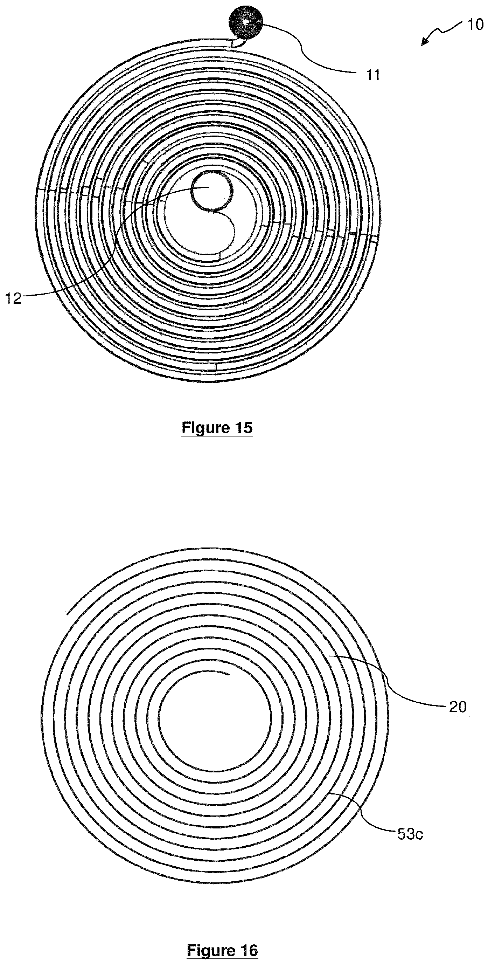

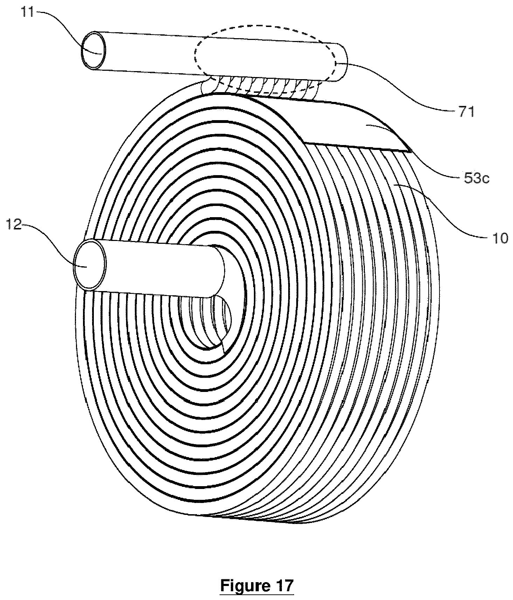

The heat exchanger 50, the first channel 10 and the second channel 20 of the fourth embodiment of the invention are depicted respectively in Figures 14 to 17. Figures 15 illustrates the first channel 10. Figures 16 illustrates a spiral-shaped compartment wall 53c corresponding to the second channel 20. Figure 17 illustrates, according to a different perspective, the heat exchanger 50 without its housing 51.

The fourth embodiment and the above-mentioned third embodiment are similar in a way that in both of these embodiments, the first channel 10 and the second channel 20 are respectively a spiral channel. On the other hand, the fourth embodiment and the above-mentioned first embodiment also present some similarities which will be described in the following paragraphs.

The first channel 10 of the fourth embodiment, being similar to the first channel 10 of the first embodiment, comprises the inflow region 71 comprising the first inlet 11, the outflow region 72 comprising the first outlet 12, and n tubes for decreasing a fluid pressure drop in the whole first channel 10, wherein "n" is a total number of the tubes. It is to note that the tubes comprised in the first channel 10 of the first embodiment are serpentine tubes, while the tubes comprised in the first channel 10 of the fourth embodiment are spiral tubes, as illustrated in Figures 6 and 17.

The second channel 20 is formed in a way to allow the first channel 10 to be inserted into the second channel 20, so that the spiral tubes T1 to Tn of the first channel 10 are immersed into the flowing second cooling medium in the second channel 20.

Each of the spiral tubes are respectively numbered as Ti, wherein "i" is an index of the spiral tube Ti, and i = 1, 2, ..., n. The spiral tubes T1 to Tn are parallel to each other. A sum of outer diameters of the n spiral tubes of the first channel 10 is approximately equal to the longitudinal length of the cylinder-shaped chamber defined by the housing 51.

Although the first channel 10 of the fourth embodiment comprises spiral tubes while the first channel 10 of the first embodiment comprises the above-mentioned serpentine tubes, the spiral tubes and serpentine tubes are similar in terms of the inner diameters Di of the inflow portions of the inflow region 71, the outflow region 72, the inner diameters Ri of the tubes Ti, as well as the material and the shape of the cross-sections of the tubes, etc.

Therefore, the description about the inflow region 71, the outflow region 72, the calculation of the values of the inner diameters Ri of the spiral tubes Ti and the inflow portion diameters Di of the fourth embodiment, are thus omitted in order to avoid redundancy.

As for the second channel 20 according to the fourth embodiment, it is formed in a way to allow the first channel 10 to be inserted into the second channel 20, so that the spiral tubes of the first channel 10 are immersed into the flowing second cooling medium in the second channel 20.

The heat exchanger comprises a spiral-shaped compartment wall 53c configured to define the second channel 20, as illustrated in Figure 16. The spiral-shaped compartment wall 53c of the fourth embodiment is similar to the compartment walls 53a, 53b of the first embodiment in terms of the function and the material. The spiral-shaped compartment wall 53c is located in the chamber of the housing 51 and between the two parallel sides of the housing 51. Moreover, the width of the spiral-shaped compartment wall 53c is approximately equal to the longitudinal length of the chamber defined by the housing 51. The second channel 20 is thus defined by the two parallel sides of the cylinder-shaped chamber of the housing 51 and the spiral-shaped compartment wall 53c.

The spiral-shaped compartment wall 53c and the housing 51 can be elements formed separately. The spiral-shaped compartment wall 53c are mounted into the housing 51. Alternatively, the spiral-shaped compartment wall 53c are formed integrally with the housing 51 by, for example, a casting process or a milling process.

According to the third and the fourth embodiments, the second flow direction 32 can be opposite to the first flow direction 31, as depicted in Figures 12 and 13. According to an alternative embodiment (not illustrated in figures), the second flow direction 32 is parallel to the first flow direction 31. Especially, the second flow direction 32 may be same with the first flow direction 31.

In this way, the heat exchanger 50 allows a heat exchange between the first and the second channels 10, 20 to occur through channel walls of the first and the second channels 10, 20 and the first and the second cooling media.

The heat exchanger according to the present invention allows thus to dissipate, for instance, 8 kW losses from a motor and a gearbox of an electric module, and to reduce the oil temperature of the motor from 110°C to 88°C. The heat exchange efficiency as well as the heat dissipation of the electric module are thus improved.

**Claims**

1. A heat exchanger (50) configured to dissipate heat generated by an electric module (100) of an automobile vehicle, the heat exchanger (50) comprising a housing (51) and a first channel (10), the first channel (10) being formed in the housing (51) and being configured to allow a first cooling medium to flow through; the heat exchanger (50) being **characterized in that** the heat exchanger (50) comprises a second channel (20) which is formed in the housing (51) and is configured to allow a second cooling medium to flow through, wherein the first channel (10) is inserted into the second channel (20) in a way that the first channel (10) is surrounded by the second channel (20).

2. The heat exchanger (50) according to the preceding claim, wherein the first and the second channels (10, 20) are respectively a serpentine channel or a spiral channel.

3. The heat exchanger (50) according to any one of the preceding claims, wherein the first channel (10) comprises:

   - a first inlet (11) configured to conduct the first cooling medium;
   - plural tubes (T1 to T6) which are connected to the first inlet (11), the tubes (T1 to T6) being parallel to each other, wherein the tubes are serpentine tubes or spiral tubes.

4. The heat exchanger (50) according to the preceding claim, wherein the tubes (T1 to T6) of the first channel (10) are immersed into the flowing second cooling medium in the second channel (20).

5. The heat exchanger (50) according to any one of claims 3 and 4, comprising one or plural compartment walls (53a, 53b, 53c) configured to define the second channel (20).

6. The heat exchanger (50) according to the preceding claim, wherein:

   - the heat exchanger (50) comprises first compartment walls (53a) and second compartment walls (53b); the inner walls of the chamber of the housing (51) comprising a first and a second inner walls (57a, 57b) which are opposite to each other; the first compartment walls (53a) being fixed to the first inner wall (57a) and the second compartment walls (53b) being fixed to the second inner wall (57b); the first and the second compartment walls (53a, 53b) being interlaced; or
   - the heat exchanger (50) comprises a spiral-shaped compartment wall (53c) located in a chamber of the housing (51) and between two parallel sides of the housing (51).

7. The heat exchanger (50) according to any one of claims 3 to 6, wherein the first channel (10) comprises an inflow region (71) comprising inflow portions, one of the inflow portions comprising the first inlet (11); the tubes (T1 to T6) being connected to the inflow portions of the inflow region (71), wherein compared to the inflow portions which are more distant from the first inlet (11), the inflow portions which are closer to the first inlet (11) present respectively a greater inflow portion diameter so as to adjust the velocity profile inside the tubes (T1 to T6).

8. The heat exchanger (50) according to any one of claims 3 to 7, wherein compared to the tubes which are more distant from the first inlet (11), the tubes which are closer to the first inlet (11) respectively present a greater inner diameter in order to adjust the velocity profile inside the tubes (T1 to T6).

9. The heat exchanger (50) according to any one of claims 5 to 8, wherein:

   - the one or plural compartment walls (53a, 53b, 53c) are mounted into the housing (51), wherein the one or plural compartment walls (53a, 53b, 53c) and the housing (51) are elements formed separately; or
   - the one or plural compartment walls (53a, 53b, 53c) are formed integrally with the housing (51) by a casting process or by a milling process.

10. The heat exchanger (50) according to any one of claims 3 to 9, wherein the tubes (T1 to T6) are made of a material of high thermal conductivity.

11. The heat exchanger (50) according to any one of claims 1 and 2, wherein the first and the second channels (10, 20) are respectively a flat serpentine channel or a flat spiral channel formed in the heat exchanger (50), the first and the second channels (10, 20) presenting each an elongated rectangular cross-section; the first channel (10) being completely inserted into the second channel (20).

12. The heat exchanger (50) according to the preceding claim, wherein:

   - the first and the second channels (10, 20) are respectively a flat serpentine tube mounted in a chamber defined by the housing (51); the widths (W) of the flat serpentine tubes (10, 20) being both approximately equal to the width of the chamber defined by the housing (51); or
   - the first and the second channels (10, 20) are respectively a flat spiral tube mounted in a cylinder-shaped chamber defined by the housing (51); the widths (W) of the flat spiral tubes (10, 20) being both approximately equal to the longitudinal length of the cylinder-shaped chamber defined by the housing (51); or
- the first and the second channels (10, 20) are formed integrally with the housing (51) so as to be embedded into the heat exchanger (50).

13. The heat exchanger (50) according to any one of the preceding claims, wherein the first cooling medium flows through the first channel (10) according to a first flow direction (31), and the second cooling medium flows through the second channel (20) according to a second flow direction (32) which is opposite to the first flow direction (31).

14. The heat exchanger (50) according to any one of the preceding claims, wherein the first and the second channels (10, 20) are formed throughout the whole volume of the heat exchanger (50).

15. An electric module (100) comprising an electric motor (102) and an inverter (103), being **characterized in that** the electric module (100) comprises a heat exchanger (50) according to any one of the preceding claims.

100

103

50

102

**Figure 1**

100

50   103

102

**Figure 2**

**Figure 3**

**Figure 4**

**Figure 5**

**Figure 6**

**Figure 7**

**Figure 8**

**Figure 9**

**Figure 10**

**Figure 11**

**Figure 12**

Figure 13

Figure 14

**Figure 15**

**Figure 16**

**Figure 17**

Europäisches
Patentamt

European
Patent Office

Office européen
des brevets

# EUROPEAN SEARCH REPORT

**Application Number**

EP 21 21 5730

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2015 028390 A (PANASONIC CORP) 12 February 2015 (2015-02-12) * abstract; figures 1-2 * ----- | 1-7,9-15 | INV. H02K5/20 H02K9/197 F28D7/04 |
| X | KR 2013 0104313 A (SUNG PLATECH CO LTD A [KR]) 25 September 2013 (2013-09-25) * paragraphs [0019] – [0067]; figures 1-5 * ----- | 1,13-15 | B60H1/00 F28D7/10 H02K9/193 H05K7/20 F28D21/00 |
| X | WO 2019/160521 A1 (LASHKUL OLEKSANDR ANATOLIYOVYCH [UA] ET AL.) 22 August 2019 (2019-08-22) * pages 3-4; figures 1-2 * ----- | 1-4,7, 9-14 | |
| X | WO 2019/160522 A1 (LASHKUL OLEKSANDR ANATOLIYOVYCH [UA] ET AL.) 22 August 2019 (2019-08-22) * pages 4-5; figures 1-2 * ----- | 1-4,7, 9-14 | |
| X | WO 2011/079483 A1 (EXTEK ENERGY EQUIPMENT ZHEJIANG LTD [CN]; NG ALFRED [CN] ET AL.) 7 July 2011 (2011-07-07) * paragraphs [0025] – [0030]; figures 1-2 * ----- | 1,2,9-14 | **TECHNICAL FIELDS SEARCHED (IPC)** H02K B60H F28D |
| X | EP 3 901 537 A1 (ZHEJIANG JIZHI NEW ENERGY AUTOMOBILE TECH CO LTD [CN]) 27 October 2021 (2021-10-27) * paragraphs [0020] – [0027]; figures 1-3 * ----- | 1,3,4,7, 10,13-15 | |
| X | KR 2012 0043916 A (LG ELECTRONICS INC [KR]) 7 May 2012 (2012-05-07) * paragraphs [0011] – [0038]; figures 1-6 * ----- | 1-7,9-15 | |

-/--

The present search report has been drawn up for all claims

| Place of search | Date of completion of the search | Examiner |
|---|---|---|
| Munich | 24 May 2022 | Merkt, Andreas |

EPO FORM 1503 03.82 (P04C01)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2013/105487 A1 (PANASONIC CORP [JP]) 18 July 2013 (2013-07-18) * paragraphs [0010] – [0014]; figure 2 * ----- | 1-7,9-15 | |
| X | GB 2 413 841 A (RUTHERFORD MATTHEW [GB]) 9 November 2005 (2005-11-09) * pages 18-20; figures 1-6 * ----- | 1-7,9-14 | |
| X | DE 10 2016 216430 A1 (HANON SYSTEMS [KR]) 1 March 2018 (2018-03-01) * paragraphs [0032] – [0038]; figures 1-2 * ----- | 1-3,5-7, 9-14 | |
| X | WO 2007/108240 A1 (MATSUSHITA ELECTRIC IND CO LTD [JP]; HAYASHI HIROKI ET AL.) 27 September 2007 (2007-09-27) * paragraphs [0038] – [0044]; figures 1-5 * ----- | 1-7,9-15 | |
| X | CN 104 776 486 A (KUNSHAN CHANGLE MOLDING TECHNOLOGY CO LTD) 15 July 2015 (2015-07-15) * abstract; figure 1 * ----- | 1-7,9-14 | TECHNICAL FIELDS SEARCHED (IPC) |
| X | JP H06 123566 A (ORION MACHINERY CO LTD) 6 May 1994 (1994-05-06) * paragraphs [0010] – [0015]; figure 1 * ----- | 1-7,9-14 | |

The present search report has been drawn up for all claims

| Place of search | Date of completion of the search | Examiner |
|---|---|---|
| Munich | 24 May 2022 | Merkt, Andreas |

EPO FORM 1503 03.82 (P04C01)

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

## ANNEX TO THE EUROPEAN SEARCH REPORT
## ON EUROPEAN PATENT APPLICATION NO.

EP 21 21 5730

This annex lists the patent family members relating to the patent documents cited in the above-mentioned European search report.
The members are as contained in the European Patent Office EDP file on
The European Patent Office is in no way liable for these particulars which are merely given for the purpose of information.

24-05-2022

| Patent document cited in search report | | Publication date | Patent family member(s) | | Publication date |
|---|---|---|---|---|---|
| JP 2015028390 | A | 12-02-2015 | JP | 6205578 B2 | 04-10-2017 |
| | | | JP | 2015028390 A | 12-02-2015 |
| KR 20130104313 | A | 25-09-2013 | NONE | | |
| WO 2019160521 | A1 | 22-08-2019 | NONE | | |
| WO 2019160522 | A1 | 22-08-2019 | NONE | | |
| WO 2011079483 | A1 | 07-07-2011 | CN | 102116585 A | 06-07-2011 |
| | | | WO | 2011079483 A1 | 07-07-2011 |
| EP 3901537 | A1 | 27-10-2021 | CN | 110345668 A | 18-10-2019 |
| | | | EP | 3901537 A1 | 27-10-2021 |
| | | | JP | 2022515470 A | 18-02-2022 |
| | | | US | 2022080801 A1 | 17-03-2022 |
| | | | WO | 2020140882 A1 | 09-07-2020 |
| KR 20120043916 | A | 07-05-2012 | NONE | | |
| WO 2013105487 | A1 | 18-07-2013 | JP | 2013145066 A | 25-07-2013 |
| | | | WO | 2013105487 A1 | 18-07-2013 |
| GB 2413841 | A | 09-11-2005 | GB | 2413841 A | 09-11-2005 |
| | | | GB | 2413842 A | 09-11-2005 |
| DE 102016216430 | A1 | 01-03-2018 | DE | 102016216430 A1 | 01-03-2018 |
| | | | KR | 2018025144 A | 08-03-2018 |
| WO 2007108240 | A1 | 27-09-2007 | NONE | | |
| CN 104776486 | A | 15-07-2015 | NONE | | |
| JP H06123566 | A | 06-05-1994 | NONE | | |

EPO FORM P0459

For more details about this annex : see Official Journal of the European Patent Office, No. 12/82